(19) Europäisches Patentamt / European Patent Office / Office européen des brevets

(11) **EP 4 024 061 B1**

(12) **EUROPEAN PATENT SPECIFICATION**

(45) Date of publication and mention
of the grant of the patent:
**27.08.2025 Bulletin 2025/35**

(21) Application number: **20855986.4**

(22) Date of filing: **23.04.2020**

(51) International Patent Classification (IPC):
**G01R 31/12** *(2020.01)*

(52) Cooperative Patent Classification (CPC):
**G01R 31/1272**

(86) International application number:
**PCT/JP2020/017567**

(87) International publication number:
**WO 2021/038960 (04.03.2021 Gazette 2021/09)**

(54) **PARTIAL DISCHARGE DETERMINATION DEVICE AND METHOD**

VORRICHTUNG UND VERFAHREN ZUR BESTIMMUNG VON PARTIELLER ENTLADUNG

DISPOSITIF ET PROCÉDÉ DE DÉTERMINATION DE DÉCHARGE PARTIELLE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.08.2019 JP 2019158281**

(43) Date of publication of application:
**06.07.2022 Bulletin 2022/27**

(73) Proprietor: **Hitachi, Ltd.**
**Tokyo 100-8280 (JP)**

(72) Inventors:
• **YAMADA, Hiromichi**
**Tokyo 100-8280 (JP)**
• **MARUYAMA, Tatsuya**
**Tokyo 100-8280 (JP)**
• **KIDO, Mitsuyasu**
**Tokyo 100-8280 (JP)**

(74) Representative: **MERH-IP Matias Erny Reichl Hoffmann**
**Patentanwälte PartG mbB**
**Paul-Heyse-Straße 29**
**80336 München (DE)**

(56) References cited:
JP-A- 2000 214 211    JP-A- 2000 214 211
JP-A- 2005 331 415    JP-A- 2005 331 415
JP-A- 2016 223 821    JP-A- H0 580 112
JP-A- H0 580 112      JP-A- H08 166 421
JP-A- H1 078 471      KR-B1- 101 574 615

• **HOZUMI NACHIRO ET AL.: "Discrimination of tree inception using partial discharge pattern recognitions with neural network", IEEJ TRANSACTIONS ON POWER AND ENERGY, vol. 111, no. 7, 20 July 1991 (1991-07-20), pages 743 - 748, XP055848873**

**Description**

Technical Field

The present invention relates to a partial discharge determination apparatus and a partial discharge determination method, and is suitably applied to, for example, a cable degradation monitoring system that monitors degradation of an underground power transmission cable.

Background Art

In an urban area, a huge power transmission network is laid in the ground, and power generated in a power plant is transmitted to each power consumer via the power transmission network. Since underground power transmission facilities have increased in the high economic growth period, and many of them have been used for 40 years from the start of operation, a technique for diagnosing aged degradation has become important.

A partial discharge measurement method is one of degradation diagnosis techniques for an underground power transmission cable. The underground power transmission cable has a structure in which a conductor through which a current flows is covered with an insulator. In a case where a void is generated in the insulator due to aging degradation, partial discharge occurs in the void, and finally dielectric breakdown occurs. The partial discharge measurement method is for observing such a partial discharge and diagnosing a degree of insulation degradation of an underground power transmission cable based on the observation result, and various companies and research organizations have conducted studies to elucidate a partial discharge generation mechanism and estimate the degree of insulation degradation from the partial discharge property.

For example, NPL 1 discloses a measurement result of the phase angle property of a partial discharge pulse from the start of electric charge application to dielectric breakdown using an experimental electrode, and a degradation diagnosis estimation method to which a pattern recognition method is applied. The phase angle property of the partial discharge pulse is a distribution pattern of the charge quantity and the occurrence phase angle of the partial discharge pulse during a plurality of cycles of the applied voltage. The change in the range of the phase angle region where the partial discharge occurs and the occurrence charge quantity is shown in the five times from the start of the electric charge application to the dielectric breakdown. In the degradation diagnosis estimating method, the phase angle property of the partial discharge is patterned into the standardized charge quantity, the standardized phase angle, and the occurrence frequency, and the similarity between this pattern and the standard pattern according to the degradation degree created in advance is compared.

PTL 1 discloses a partial discharge measurement method capable of determining the presence or absence of a partial discharge using a neural network. Unlike the pattern of NPL 1, the pattern used here is a standardized charge quantity/standardized phase angle that is listed in time series every t cycle. In the technique of NPL 1, since the charge quantity and the phase angle are collectively patterned as the occurrence frequency for a plurality of cycles (600 cycles), there is a problem that time information of the occurrence phase angle is lost and the presence or absence of the partial discharge may be erroneously determined.

Furthermore, PTL 2 discloses an insulation diagnosis system capable of improving diagnosis accuracy by applying a hidden Markov model. Since the neural network used in the insulation diagnosis system in the related art is not possible to include the temporal causal relationship of the feature amount stochastically changing with the lapse of time, there is a problem that the accuracy is low when the neural network is applied to the diagnosis in the insulation state by the partial discharge. In the hidden Markov model, data varying in time series is expressed by a probabilistic model. Furthermore, PTL 3 discloses a partial discharge monitoring and diagnosing system for power equipment using a signal detecting method based on a statistical phase pattern to remotely detect a partial discharge in internal power equipment and a power device system housing such as a high-voltage cable and the like. Eventually, PTL 4 discloses a partial discharge judging method capable of judging accurately the discharge state of a partial discharge by measuring a partial discharge signal, wherein a CPU divides a discharge electric charges amount and a charged potential phase into q and p pieces, respectively, to represent a phase $\phi$-electric charges amount q by a plurality of elements, thereby acquiring a $\phi$-q-n pattern allocating the number of occurrence to a value of each element.

Citation List

Patent Literature

PTL 1: JP 10-78471 A

PTL 2: JP 2005-331415 A
PTL 3: KR 101 574 615 B1
PTL 4: JP 2000/214 211 A

Non-Patent Literature

NPL 1: KOMORI Fumitaka and three others, "Degradation Diagnosis and Estimation of Residual Life of Insulating Material using Pattern Recognition of Phase Angle Resolved Partial Discharge Pulse Occurrence Distribution", The Institute of Electrical Engineers of Japan, 1993, Vol. 113-A, No. 8, p. 586-593

Summary of Invention

Technical Problem

Since the technique disclosed in NPL 1 uses the distribution patterns of the charge quantity, the phase angle, and the occurrence frequency of the partial discharge pulses in a plurality of cycles (for example, 600), there is a disadvantage that the information on the temporal change of the partial discharge cannot be included while there is an advantage that the feature of the pattern as a whole appear and are easy to identify.

In addition, since the technique disclosed in PTL 1 uses the distribution patterns of the charge quantity, the phase angle, and the time of the partial discharge pulses in t cycle, and there is a problem that t as the number of measurement cycles cannot be increased as in NPL 1 while there is an advantage that the information on the temporal change of the partial discharge can be included. This is because the scale of the neural network increases. Therefore, the feature of the pattern as a whole is difficult to appear, and determination may be difficult.

Furthermore, according to the technique disclosed in PTL 2, there are a normal state and each insulation degradation state of the insulator, and in each state, a property amount related to insulation is patterned and provided as a parameter, so that there is a possibility that diagnosis accuracy can be improved. On the other hand, in FIG. 1 of PTL 2, there is a problem that a normal state S1, a next insulation degradation state S2, a next insulation degradation state S3, and a final state S4 of the insulator have only unidirectional state transition probabilities, and when the state transition is wrong, the insulation degradation state becomes worse than the actual state.

The present invention has been made in view of the above points, and an object of the present invention is to propose a partial discharge determination apparatus and a partial discharge determination method capable of increasing a feature amount by including temporal information of partial discharge in a distribution pattern of a charge quantity, a phase angle, and an occurrence frequency of a partial discharge pulse, and improving accuracy of partial discharge determination.

Solution to Problem

The invention is set out in the appended set of claims. Preferable embodiments are defined in the dependent claims.

According to the partial discharge apparatus and the partial discharge method of the present invention, it is possible to determine the degree of progress of partial discharge including temporal information of the partial discharge.

Advantageous Effects of Invention

According to the present invention, it is possible to realize a partial discharge determination apparatus and a partial discharge determination method capable of accurately determining the degree of progress of the partial discharge.

BriefDescription of Drawings

[FIG. 1] FIG. 1 is a block diagram illustrating an overall configuration of an underground power transmission cable degradation monitoring system according to a present embodiment.
[FIG. 2] FIG. 2 is a block diagram illustrating a schematic configuration of a partial discharge determination apparatus.
[FIG. 3] FIG. 3 is a block diagram illustrating a flow of a partial discharge determination process.
[FIG. 4] FIG. 4 is a diagram for explaining a partial discharge pulse signal and an applied voltage signal.
[FIG. 5] FIG. 5(A) is a diagram illustrating a state of a phase-resolved partial discharge pattern at the start of partial discharge, FIG. 5(B) is a diagram illustrating a state of a phase-resolved partial discharge pattern at the middle stage of the partial discharge, and FIG. 5(C) is a diagram illustrating a state of a phase-resolved partial discharge pattern immediately before dielectric breakdown.

[FIG. 6] FIGS. 6(A) and 6(B) are diagrams for explaining a standardized phase-resolved partial discharge pattern.

[FIG. 7] FIGS. 7(A) and 7(B) are diagrams for explaining standardization of a partial discharge pulse.

[FIG. 8] FIG. 8 is a diagram for explaining a differential data generation unit according to a first embodiment.

[FIG. 9] FIG. 9 is a diagram for explaining a neural network according to the first embodiment.

[FIG. 10] FIG. 10 is a flowchart illustrating a processing procedure of a process of registering partial discharge pulse information.

[FIG. 11] FIG. 11 is a flowchart illustrating a processing procedure of a process of standardizing partial discharge pulse charge quantity.

[FIG. 12] FIG. 12 is a flowchart illustrating a processing procedure of a process of initializing counter.

[FIG. 13] FIG. 13 is a flowchart illustrating a processing procedure of a process of counting the number of standardized partial discharge pulses.

[FIG. 14] FIG. 14 is a diagram for explaining a differential data generation unit according to a second embodiment.

[FIG. 15] FIG. 15 is a diagram for explaining a differential data generation unit according to a third embodiment.

[FIG. 16] FIG. 16 is a diagram for explaining a neural network according to the third embodiment.

[FIG. 17] FIG. 17 is a diagram for explaining a neural network according to the fourth embodiment.

Description of Embodiments

Hereinafter, an embodiment of the present invention will be described in detail with reference to the drawings.

(1) First embodiment

(1-1) Configuration of underground power transmission cable degradation monitoring system according to present embodiment

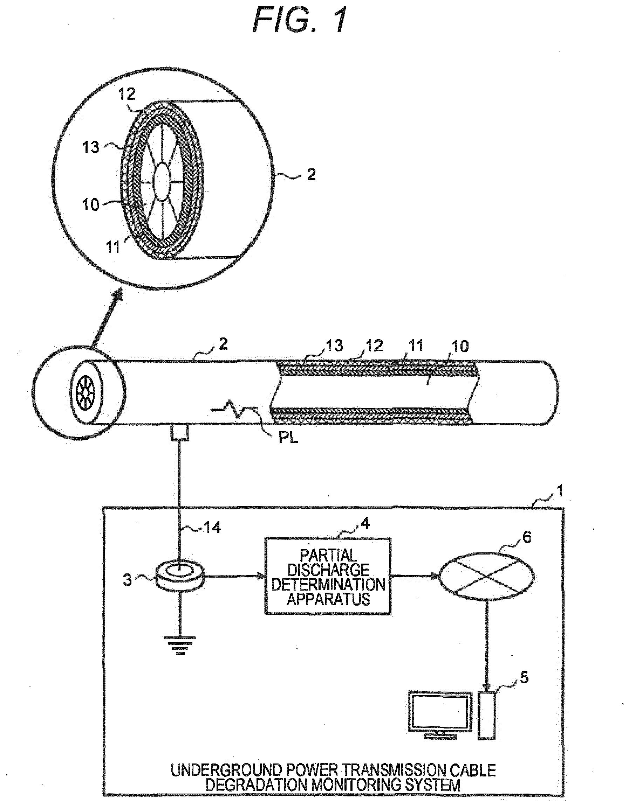

In FIG. 1, reference numeral 1 denotes an underground power transmission cable degradation monitoring system to which the present invention is applied as a whole. An underground power transmission cable degradation monitoring system 1 is a system that monitors degradation of an underground power transmission cable 2, and includes a clamp type high-frequency current transformer (CT) 3, a partial discharge determination apparatus 4, and a cable degradation monitoring apparatus 5.

In the case of an OF (Oil Filled) cable that maintains insulation with kraft paper and oil, the underground power transmission cable 2 is configured by sequentially laminating an insulator 11 made of kraft paper immersed in insulating oil, a metal sheath 12 for enclosing oil, and an anticorrosion layer 13 for corrosion prevention on a conductor 10 through which electricity flows. The metal sheath 12 is grounded via a metal sheath ground line 14, so that when a partial discharge occurs in the underground power transmission cable 2, the partial discharge pulse can be released to the ground via the metal sheath ground line 14.

The clamp type high-frequency CT3 is configured to include a clamp high frequency current sensor, and outputs a partial discharge pulse signal including a pulse that rises to a voltage level corresponding to the charge quantity of each partial discharge pulse PL flowing through the metal sheath ground line 14 to the partial discharge determination apparatus 4. In the following description, the pulse included in the partial discharge pulse signal is referred to as a partial discharge pulse PL for easy understanding.

The partial discharge determination apparatus 4 is equipped with a partial discharge determination function of determining a degree of progress of partial discharge in the target underground power transmission cable (hereinafter, this is referred to as a target underground power transmission cable) 2 based on a partial discharge pulse signal given from the clamp type high-frequency CT3. The partial discharge determination apparatus 4 executes a partial discharge determination process of determining a degree of progress of the partial discharge based on the partial discharge determination function, and transmits a processing result as a partial discharge determination signal to the cable degradation monitoring apparatus 5 via the network 6.

The cable degradation monitoring apparatus 5 includes, for example, a computer device such as a personal computer or a workstation, records necessary information included in a partial discharge determination signal given from the partial discharge determination apparatus 4, estimates a degradation degree of the underground power transmission cable 2 by combining a determination result of the partial discharge with a time change, and displays the estimation result.

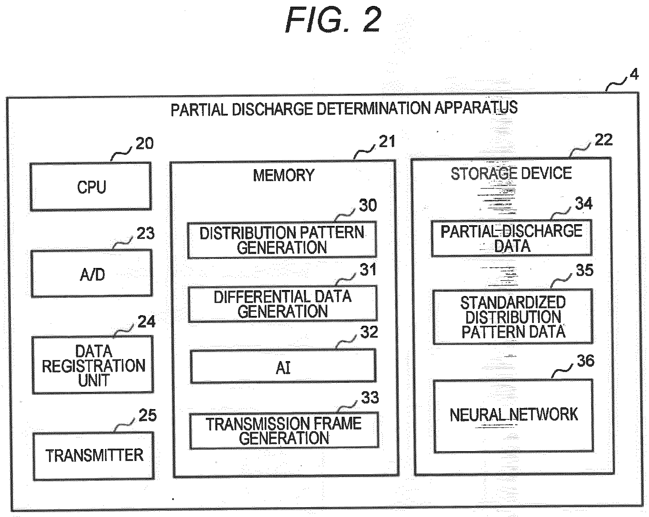

FIG. 2 illustrates a schematic configuration of the partial discharge determination apparatus 4. As illustrated in FIG. 2, the partial discharge determination apparatus 4 includes a computer device including a central processing unit (CPU) 20, a memory 21, a storage device 22, an analog/digital (A/D) converter 23, a data registration unit 24, and a transmitter 25.

The CPU 20 is a processor that controls the entire operation of the partial discharge determination apparatus 4. The memory 21 includes a volatile semiconductor memory and the like, and is used as a work memory of the CPU 20. Programs such as a distribution pattern generation program 30, a differential data generation program 31, an artificial intelligence (AI) program 32, and a transmission frame generation program 33 to be described later are loaded from the storage device 22 and held in the memory 21.

The storage device 22 includes a nonvolatile large-capacity storage device such as a hard disk device, a solid state drive (SDD), or a flash memory, and stores various programs, data to be stored for a long period of time, and the like. The storage device 22 also stores and hold partial discharge data 34, standardized distribution pattern data 35, and data of the neural network 36, which will be described later.

The A/D converter 23 is configured to include a general-purpose A/D converter. The data registration unit 24 is configured to include a field programmable gate array (FPGA). A function of the data registration unit 24 will be described later. The transmitter 25 is configured to include, for example, a network interface card (NIC), and transmits the determination result of the partial discharge determination by the partial discharge determination apparatus 4 to the cable degradation monitoring apparatus 5 (FIG. 1) via the network 6 (FIG. 1).

(1-2) Partial discharge determination process

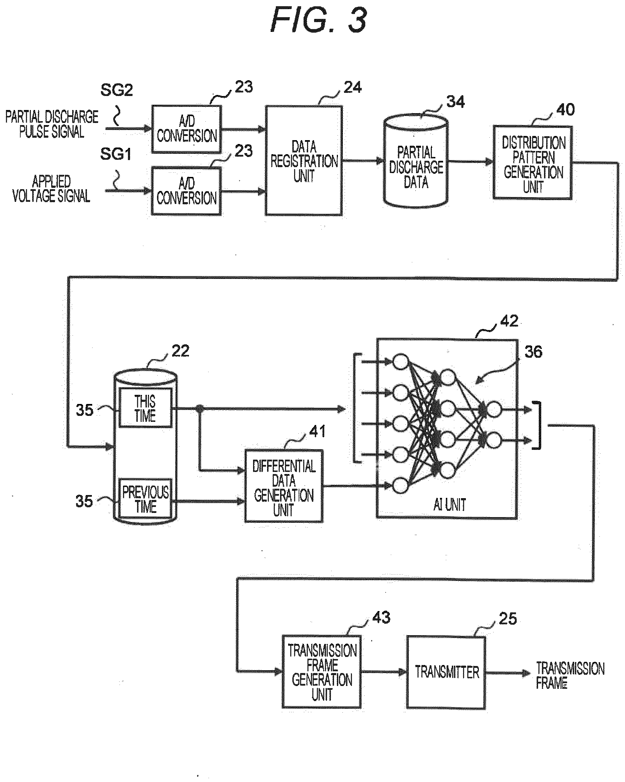

FIG. 3 illustrates a flow of the partial discharge determination process performed by the partial discharge determination apparatus 4. In the drawing, a distribution pattern generation unit 40, a differential data generation unit 41, an AI unit 42, and a transmission frame generation unit 43 are functional units implemented by the CPU 20 executing the distribution pattern generation program 30, the differential data generation program 31, the AI program 32, or the transmission frame generation program 33 described above with respect to FIG. 2 loaded from the storage device 22 to the memory 21.

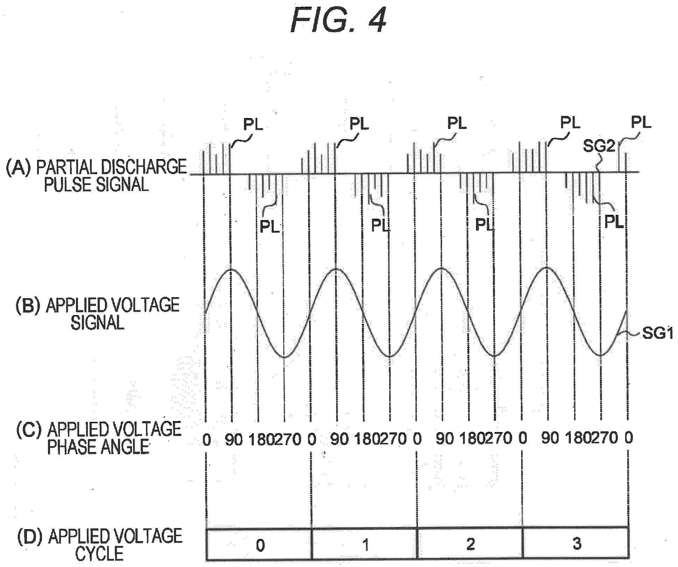

As illustrated in FIG. 3, in the partial discharge determination apparatus 4, an applied voltage signal SG1 as illustrated in the second stage of FIG. 4 obtained by stepping down the voltage (hereinafter, this is referred to as an applied voltage) of electricity flowing through the underground power transmission cable 2 (FIG. 1) to about 5 V is provided to the A/D converter 23. Then, the A/D converter 23 performs A/D conversion on the applied voltage signal SG1, and outputs digital data of the applied voltage signal SG1 thus obtained to the data registration unit 24.

A partial discharge pulse signal SG2 including each partial discharge pulse PL generated in the underground power transmission cable 2 as illustrated in the uppermost stage of FIG. 4 and given from the clamp type high-frequency CT3 (FIG. 1) is input to the A/D converter 23. Then, the A/D converter 23 performs A/D conversion on the partial discharge pulse signal SG2, and outputs digital data of the partial discharge pulse signal SG2 thus obtained to the data registration unit 24.

The data registration unit 24 extracts each partial discharge pulse PL included in the partial discharge pulse signal SG2, and acquires a digital value of each partial discharge pulse PL as a charge quantity of the partial discharge pulse PL. For each partial discharge pulse PL, the data registration unit 24 acquires a phase angle (hereinafter, this is referred to as a phase angle or an occurrence phase angle of the partial discharge pulse PL) of the applied voltage signal SG1 at a time point when the partial discharge pulse PL is generated. As will be described later, the phase angle of the partial discharge pulse PL acquired by the data registration unit 24 at this time is a phase angle (hereinafter, this is referred to as a standardized phase angle) obtained by standardizing 0 degrees to 360 degrees to an integer value of 0 to 15. Then, the data registration unit 24 stores the charge quantity and the standardized phase angle of each partial discharge pulse PL acquired in this manner in the storage device 22 (FIG. 1) as partial discharge data 34.

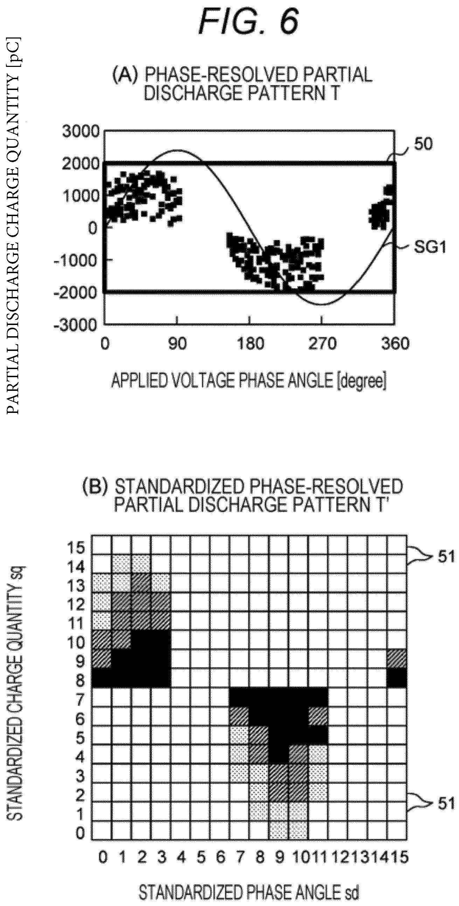

Based on the partial discharge data 34 of each partial discharge pulse PL stored in the storage device 22, the distribution pattern generation unit 40 sequentially generates a standardized phase-resolved partial discharge pattern T' to be described later with respect to FIG. 6(B) obtained by standardizing a distribution pattern (hereinafter, this is referred to as a phase-resolved partial discharge pattern) T of a combination of a charge quantity and a standardized phase angle of each partial discharge pulse PL generated in several cycle periods of an applied voltage signal SG1 to be described later with respect to FIG. 6(A), and sequentially stores data of the generated standardized phase-resolved partial discharge pattern T' in the storage device 22 as standardized distribution pattern data 35.

The standardized distribution pattern data 35 of the current standardized phase-resolved partial discharge pattern T' stored in the storage device 22 is then read by the AI unit 42. Furthermore, at this time, the differential data generation unit 41 reads the standardized distribution pattern data 35 of the current standardized phase-resolved partial discharge pattern T' and the standardized distribution pattern data 35 of the previous standardized phase-resolved partial discharge pattern T' stored in the storage device 22, generates differential data representing a difference between the previous and current standardized phase-resolved partial discharge patterns T' based on these two pieces of standardized distribution pattern data 35, and outputs the generated differential data to the AI unit 42.

Based on the standardized distribution pattern data 35 of the current standardized phase-resolved partial discharge pattern T' and the differential data of the previous and current standardized phase-resolved partial discharge patterns T', the AI unit 42 performs machine learning to determine whether a degree of the progress of the partial discharge of the current target underground power transmission cable 2 belongs to the category at the start of the partial discharge, the middle stage of the partial discharge, or immediately before the dielectric breakdown.

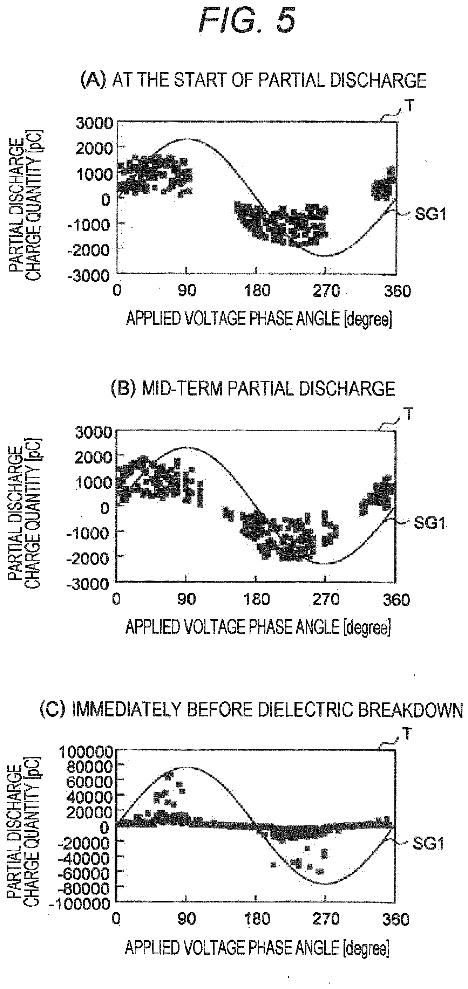

Here, FIGS. 5(A) to 5(C) illustrate an example of a phase-resolved partial discharge pattern T in which points representing the respective partial discharge pulses PL generated in a plurality of cycles (for example, 50 cycles) of the applied voltage are plotted on a coordinate plane in which the charge quantity of the partial discharge pulse PL is taken on the vertical axis and the phase angle of the applied voltage is taken on the horizontal axis.

FIG. 5(A) is an example of a phase-resolved partial discharge pattern T at the start of partial discharge. In this example, a positive partial discharge pulse occurs from the vicinity of the zero-cross point of the applied voltage from negative to positive, and a negative partial discharge pulse occurs from the vicinity of the zero-cross point of the applied voltage from positive to negative. Specifically, it is illustrated that a partial discharge pulse having a positive charge quantity occurs when the phase angle of the applied voltage is in the range of -30 degrees to 90 degrees, and a partial discharge pulse having a negative charge quantity occurs when the phase angle of the applied voltage is in the range of 150 degrees to 270 degrees.

FIG. 5(B) is an example of a phase-resolved partial discharge pattern T at the middle stage of partial discharge. In the middle stage of the partial discharge, the charge quantity of the partial discharge pulse increases as compared with the distribution pattern of FIG. 5(A), and the range of the phase angle at which the partial discharge pulse occurs also expands.

FIG. 5(C) illustrates an example of a phase-resolved partial discharge pattern T in the late stage of the partial discharge and immediately before the dielectric breakdown. FIG. 5(C) illustrates that a partial discharge pulse occurs at all phase angles of the applied voltage, and the charge quantity ranges from + tens of thousands of pC to - tens of thousands of pC.

As described above, the phase-resolved partial discharge pattern T gradually changes from the initial stage of the partial discharge to immediately before the dielectric breakdown. Specifically, as the degradation of the underground power transmission cable 2 due to the partial discharge progresses, the number of places where the partial discharge occurs increases as described above, and the charge quantity of the partial discharge also increases.

Therefore, it is considered that the temporal variation of the partial discharge occurring in the target underground power transmission cable 2 can be detected based on the difference between the plurality of phase-resolved partial discharge patterns T acquired continuously in time, and the determination accuracy of the partial discharge determination can be improved by using the variation amount as one of the determination elements of the degree of progress of the partial discharge.

Therefore, in the present embodiment, as described above, based on the standardized distribution pattern data 35 of the current standardized phase-resolved partial discharge pattern T' and the differential data of the previous and current standardized phase-resolved partial discharge patterns T', the machine learning to the degree of the progress of the partial discharge of the current target underground power transmission cable 2. In addition, the AI unit 42 determines the degree of progress of the partial discharge in the target underground power transmission cable 2 using the neural network 36 obtained by the machine learning, and outputs the determination result to the transmission frame generation unit 43.

The transmission frame generation unit 43 generates a transmission frame in a predetermined format storing the determination result given from the AI unit 42, and outputs the generated frame to the transmitter 25. Thus, the transmitter 25 transmits the transmission frame provided from the transmission frame generation unit 43 as a partial discharge determination signal to the cable degradation monitoring apparatus 5 (FIG. 1) via the network 6 (FIG. 1).

FIG. 6(B) illustrates the above-described standardized phase-resolved partial discharge pattern T' obtained by standardizing the phase-resolved partial discharge pattern T illustrated in FIG. 6(A). In order for the AI unit 42 (FIG. 3) to easily classify the distribution pattern of the partial discharge pulse PL into the category (at start of partial discharge, middle stage of partial discharge or immediately before dielectric breakdown) according to the degree of progress of the partial discharge using the neural network 36 (FIG. 3), the distribution pattern generation unit 40 (FIG. 3) standardizes the phase-resolved partial discharge pattern T as illustrated in FIG. 6(A) based on the partial discharge data 34 stored in the storage device 22, and generates the standardized phase-resolved partial discharge pattern T' illustrated in FIG. 6(B) in which the occurrence number of partial discharges for each combination of the standardized charge quantity and the standardized phase angle are aggregated.

Specifically, the distribution pattern generation unit 40 first sets a range (hereinafter, this is referred to as a window) 50 including all the points representing the partial discharge pulse PL in FIG. 6(A) on the phase-resolved partial discharge pattern T in FIG. 6(A). At this time, the vertical length of a window 50 representing the discharge charge quantity of the partial discharge is set so that the charge quantity from 0 to the top and the charge quantity from 0 to the bottom are the same. That is, the larger absolute value of the positive maximum value and the negative maximum value of the partial discharge charge quantity is the length from 0 to the top and the length from 0 to the bottom of the window 50.

Next, the distribution pattern generation unit 40 equally divides each of the longitudinal direction and the lateral direction of the window 50 in FIG. 6(A) into a predetermined number, divides the inside of the window 50 into a plurality of small regions (hereinafter, this is referred to as a cell) 51 as in FIG. 6(B), and sets a counter (hereinafter, this is referred to as a partial discharge pulse counter) for counting the number of partial discharge pulses corresponding to each cell 51.

FIG. 6(B) illustrates an example in which the window 50 is equally divided into 16 pieces in both the longitudinal direction and the lateral direction. In the vertical direction of FIG. 6(B), one of the cells 51 represents a standardized charge quantity (hereinafter, this is referred to as a standardized charge quantity) sq. In FIG. 6(A), since the range of the window 50 in the longitudinal direction is-2000. pC to +2000 pC, in FIG. 6(B), sq = 0 corresponds to a range of -2000 pC or more and less than -1750 pC, and sq = 1 corresponds to a range of -1750 pC or more and less than -1500 pC. The same applies to sq = 2 to sq = 6. In addition, sq = 7 corresponds to a range of -250 pC or more and less than 0 pC, sq = 8 corresponds to a range of more than 0 pC and 250 pC or less, and sq = 9 corresponds to a range of more than 250 pC and 500 pC or less. The same applies to sq = 10 to sq = 14. sq = 15 corresponds to a range of more than 1750 and 2000 pC or less.

In the lateral direction of FIG. 6(B), one cell 51 represents one standardized phase angle sd. Therefore, in FIG. 6(B), sd = 0 corresponds to a range of 0 degrees or more and less than 22.5 degrees, and sd = 1 corresponds to a range of 22.5 degrees or more and less than 45 degrees. The same applies to sd = 2 to sd = 15.

Next, the distribution pattern generation unit 40 standardizes the charge quantity of each target partial discharge pulse PL to an integer value of 0 to 15. Then, for each partial discharge pulse PL, the distribution pattern generation unit 40 counts up a partial discharge pulse counter of the cell 51 corresponding to a combination of the standardized charge quantity (standardized charge quantity) and the standardized phase angle generated by the distribution pattern generation unit 40. As a result, the number (hereinafter, this is referred to as the number of partial dischargepulses) sqc of the corresponding partial discharge pulses PL is counted for each cell 51.

In FIG. 6(B), for easy understanding, each cell 51 is colored at a concentration corresponding to the number of partial discharge pulses sqc counted by the partial discharge pulse counter of the cell 51. Specifically, in FIG. 6(B), colorless indicates that the standardized partial discharge pulse number sqc is 0, and each cell 51 is colored such that the concentration increases in the order of light gray, dark gray, and black as the value of the standardized partial discharge pulse number sqc increases.

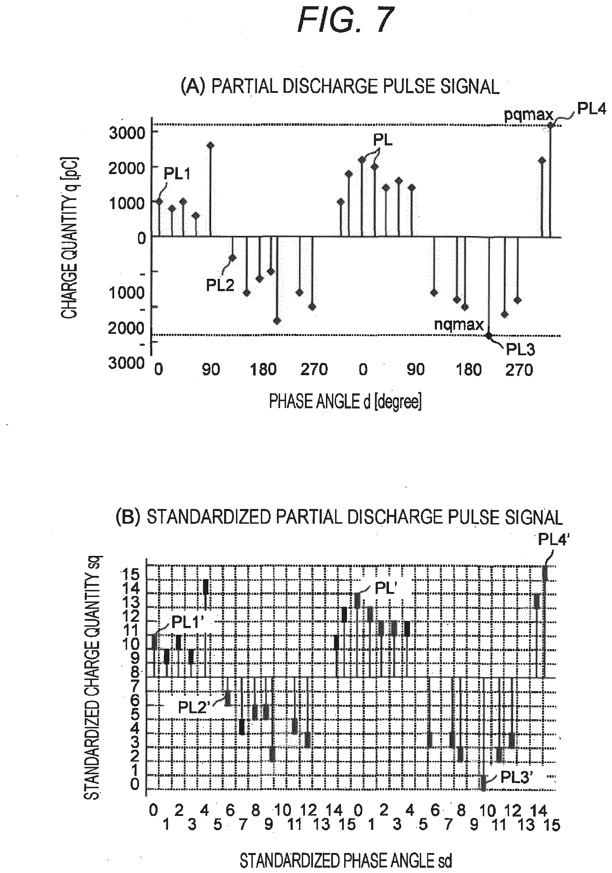

The charge quantity of the partial discharge pulse PL can be standardized as follows. FIG. 7(A) illustrates a partial discharge pulse PL for a period of two cycles of the applied voltage. In the drawings, PL1 is the first partial discharge pulse of the first cycle of the applied voltage, and PL2 is the first negative partial discharge pulse of the first cycle of the applied voltage. PL3 is a partial discharge pulse having a negative charge quantity with the largest absolute value among the partial discharge pulses measured this time, and PL4 is a positive partial discharge pulse PL3 with the largest absolute value among the partial discharge pulses measured this time. Here, the charge quantity of the partial discharge pulse PL3 is referred to as nqmax, and the charge quantity of the partial discharge pulse PL4 is referred to as pqmax.

FIG. 7(B) illustrates a state in which the charge quantity of each partial discharge pulse PL for a cycle period of two applied voltages corresponding to FIG. 6(A) is standardized. In the drawing, PL1' to PL4' correspond to the partial discharge pulses PL1 to PL4 of FIG. 7(A), respectively. The standardized charge quantity sq of each partial discharge pulse PL can be calculated by the following equation:
[Equation 1]

$$qmax = max(pqmax, -nqmax) \qquad (1);$$

and
the following equation:
[Equation 2]

$$sq = int(16 \times (q + qmax)/(2 \times qmax)) \qquad (2).$$

Equation (1) represents that the larger one of the absolute values of the maximum value pqmax of the positive charge quantity of the partial discharge pulse PL and the maximum value nqmax of the negative charge quantity is referred to as qmax. In addition, Equation (2) represents that the charge quantity q is converted so as to always have a positive value by adding qmax to the charge quantity q of the partial discharge pulse PL, the addition result is then divided by twice qmax (that is, the vertical length of the window in FIG. 5(A)), further multiplied by the vertical standardization number (here, 16), and then the fractional value portion is discarded from the multiplication result to obtain the integer value ("int ()"), thereby obtaining the standardized charge quantity sq.

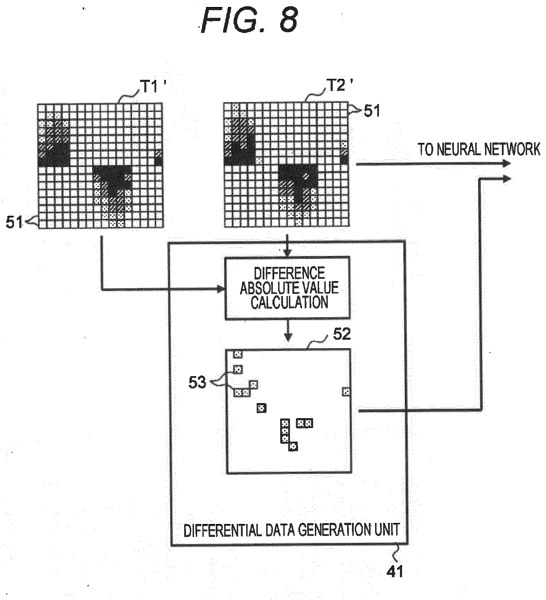

On the other hand, FIG. 8 illustrates specific processing contents of the differential data generation unit 41. As described above, the differential data generation unit 41 acquires the previous standardized phase-resolved partial discharge pattern T1' and the current standardized phase-resolved partial discharge pattern T2' from the storage device 22, and calculates the absolute value (hereinafter, this is referred to as a partial discharge occurrence number difference absolute value) of the difference between the occurrence number of the partial discharge pulses PL in these two standardized phase-resolved partial discharge patterns T1' and T2' for each cell 51.

The distribution (hereinafter, this is referred to as a partial discharge occurrence number difference absolute value distribution) 52 of the partial discharge occurrence number difference absolute value between the previous and current standardized phase-resolved partial discharge patterns T1' and T2' calculated in this way represents a difference between the previous standardized phase-resolved partial discharge pattern T1' and the current standardized phase-resolved partial discharge pattern T2'. The difference between the charge quantities in the two phase-resolved partial discharge patterns T is reflected in the value of the cell 53 in the vertical direction, and the difference between the phase angles is reflected in the value of the cell 53 in the horizontal direction. As a result, the degree of variation in the charge quantity of the partial discharge pulse PL and the degree of variation in the occurrence phase angle can be recognized based on the standardized partial discharge occurrence number difference absolute value distribution patterns T1' and T2'.

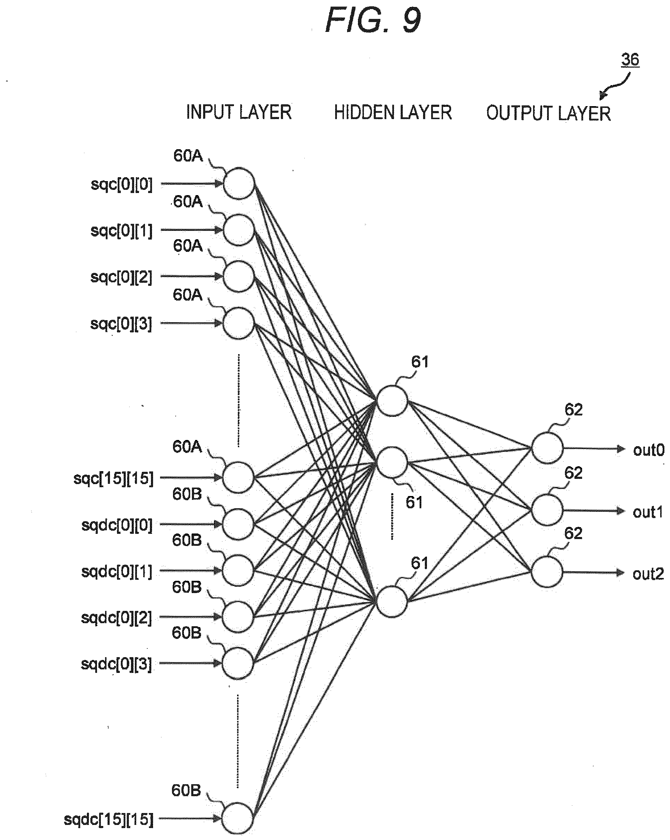

FIG. 9 illustrates a configuration example of the neural network 36 used by the AI unit 42. FIG. 9 is an example of a case where the neural network 36 includes a perceptron including an input layer, a hidden layer, and an output layer.

In the neural network 36, a first unit 60A corresponding to each cell 51 of the standardized partial discharge occurrence number difference absolute value distribution pattern T' described above with reference to FIG. 6(B) is provided in the input layer, and the count value sqc [sq] [sd] of the partial discharge pulse counter of the corresponding cell 51 in the current standardized phase-resolved partial discharge pattern T2' is input to each of the first units 60A.

In the neural network 36, a first unit 60B corresponding to each cell 53 (refer to FIG. 8) of the partial discharge occurrence number difference absolute value distribution 52 described above with reference to FIG. 8 is also provided in the input layer, and the partial discharge occurrence number difference absolute value of the corresponding cell 51 in the previous and current standardized phase-resolved partial discharge patterns T1' and T2' calculated by the differential data generation unit 41 is input to the first unit 60B.

The hidden layer is provided with a smaller number of second units 61 than the total number of first units 60A and 60B in the input layer. The value input to each of the first units 60A and 60B of the input layer is weighted by the weight set between each of the first units 60A and 60B and each of the second units 61, and is output to each of the second units 61. Each second unit 61 calculates a sum of input values from each of the first units 60A and 60B.

The output layer is provided with a smaller number of third units 62 than the total number of second units 61. The sum of the input values to the second unit calculated in each of the second units 61 of the hidden layer is weighted by the weight set between the second unit 61 and each of the third units 62 and is output to each of the third units 62. Each of the third units 62 calculates a sum of input values from each of the second units 61, and outputs a calculation result.

Note that, in the present embodiment, three third units 62 of the output layer are provided, and thereby inputs to the input layer are classified into three categories and output from the neural network 36. Then, the output of the neural network 36 is transmitted as a partial discharge determination, signal to the cable degradation monitoring apparatus 5 (FIG. 1) via the transmission frame generation unit 43 (FIG. 3) and the transmitter 25 (FIG. 3) as a determination result of the progress of the partial discharge.

(1-3) Various processes based on partial discharge determination function

Next, specific processing contents of various types of processes executed in the partial discharge determination apparatus 4 based on the partial discharge determination function will be described.

(1-3-1) Process of data registration unit

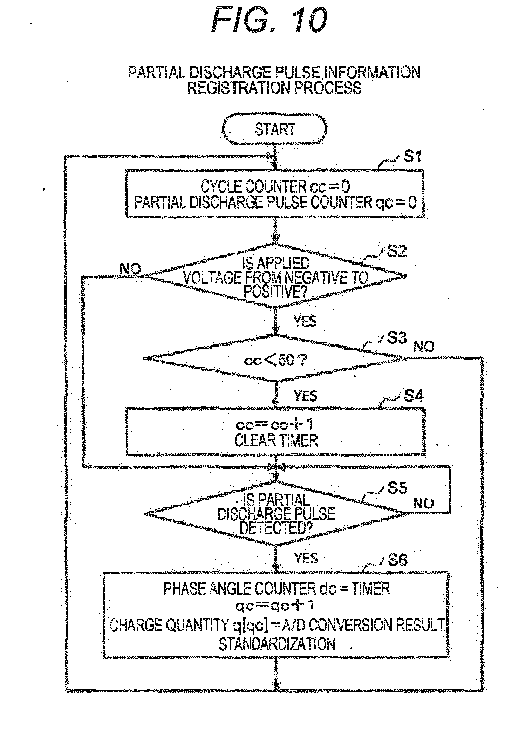

FIG. 10 illustrates a processing procedure of a process of registering partial discharge pulse information executed by the data registration unit 24 (FIG. 3). The data registration unit 24 detects the charge quantity and the standardized phase angle of each partial discharge pulse PL included in the partial discharge pulse signal SG2 according to the processing procedure illustrated in FIG. 10, and registers them in the storage device 22. In the following description, it is assumed that the charge quantity and the standardized phase angle of each partial discharge pulse occurring in the period of 50 cycles of the applied voltage are stored in the storage device 22.

When the partial discharge determination apparatus 4 is activated, the data registration unit 24 starts the process of registering the partial discharge pulse information as illustrated in FIG. 10. First, the data registration unit resets (sets to 0) a count value cc of a cycle counter for counting cycles of an applied voltage flowing through the underground power transmission cable 2 (FIG. 1), and resets a count value qc of a partial discharge pulse counter for counting the number of detected partial discharge pulses PL (S1).

Subsequently, the data registration unit 24 determines whether the applied voltage of the electricity flowing through the underground power transmission cable 2 has changed from negative to positive based on the applied voltage signal SG1 (FIG. 3) (S2). Then, when a negative result is obtained in this determination, the data registration unit 24 proceeds to step S5.

On the other hand, when an affirmative result is obtained in the determination in step S2, the data registration unit 24 determines whether the count value cc of the cycle counter is less than 50 (S3). Then, when an affirmative result is obtained in this determination, the data registration unit 24 increments the counter value cc of the cycle counter (increments by 1), and clears (resets) a timer (not illustrated) that counts a clock of 1 MHz used as a counter (hereinafter, this is referred to as a phase angle counter) of the occurrence phase angle of the partial discharge pulse PL (S4).

Next, the data registration unit 24 monitors the partial discharge pulse signal SG2 (FIG. 3) provided from the clamp type high-frequency CT3 (FIG. 1) and waits for detection of the partial discharge pulse PL (S5). Then, when the data registration unit 24 eventually detects the partial discharge pulse PL included in the partial discharge pulse signal SG2, the data registration unit acquires the charge quantity of the partial discharge pulse PL and the standardized phase angle obtained by standardizing the occurrence phase angle, and stores them in the storage device 22 in association with the partial discharge pulse PL (S6).

Specifically, in step S6, the data registration unit 24 first acquires the value of the timer at the moment when the partial discharge pulse PL is detected as the count value dc of the phase angle counter, and increments the count value qc of the partial discharge pulse counter. Thereafter, the data registration unit 24 acquires a digital value of the partial discharge pulse signal SG2 provided from the A/D converter 23 (FIG. 3) at that time as the charge quantity q [qc] of the partial discharge pulse PL. Further, the data registration unit 24 divides the count value dc of the phase angle counter at that time by 1250 (when the partial discharge pulse charge quantity is equally divided into 16 as in FIG. 6(B)), and further calculates a value obtained by discarding the fractional value from the division result as the standardized phase angle of the partial discharge pulse PL.

Thereafter, the data registration unit 24 returns to step S1, and thereafter, repeats the processes after step S1 in the same manner as described above.

(1-3-2) Process of distribution pattern generation unit

(1-3-2-1) Process of standardizing partial discharge pulse charge quantity

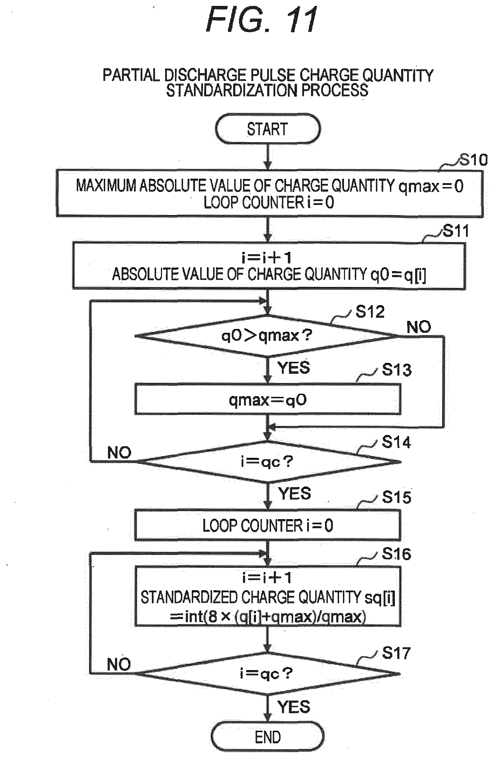

FIG. 11 illustrates a processing procedure of a process of standardizing partial discharge pulse charge quantity executed by the distribution pattern generation unit 40 (FIG. 3). The distribution pattern generation unit 40 standardizes the charge quantity of each partial discharge pulse PL occurring in the period of 50 cycles of the applied voltage according to the processing procedure illustrated in FIG. 11.

In practice, the distribution pattern generation unit 40 starts the process of standardizing the partial discharge pulse charge quantity at the timing when a negative result is obtained in step S3 of FIG. 10. First, the distribution pattern generation unit resets (sets to 0) the stored maximum absolute value (hereinafter, this is referred to as a charge quantity maximum absolute value) $q_{max}$ of the charge quantity of the partial discharge pulse PL, and resets a count value i of a loop counter to be described later (S10).

Subsequently, the distribution pattern generation unit 40 increments the count value i of the loop counter, substitutes the absolute value of the charge quantity q [i] of the i-th detected partial discharge pulse PL in the target partial discharge pulse group (an aggregate of the partial discharge pulses detected in the previous process of registering the partial discharge pulse information, hereinafter, referred to as a target partial discharge pulse group) at that time into the charge quantity q0 (S11), and determines whether or not the value of the charge quantity q0 at this time is larger than the current charge quantity maximum absolute value $q_{max}$ (S12).

If a negative result is obtained in this determination, the distribution pattern generation unit 40 proceeds to step S14. On the other hand, when obtaining an affirmative result in the determination of step S12, the distribution pattern generation unit 40 updates the value of the maximum absolute value of the charge quantity to the value of the charge quantity q0 (S13).

Thereafter, the distribution pattern generation unit 40 determines whether or not the value of the count value i of the loop counter has become the count value qc of the partial discharge pulse counter finally obtained in step S6 of FIG. 10 for the target partial discharge pulse group (that is, the number of partial discharge pulses PL constituting the target partial discharge pulse group) (S14).

Then, when a negative result is obtained in this determination, the distribution pattern generation unit 40 returns to step S12, and thereafter, repeats the processes of steps S12 to S14 until an affirmative result is obtained in step S14. By this repetitive processing, the charge quantity of the partial discharge pulse PL having the largest absolute value of the charge quantity among the partial discharge pulses PL constituting the target partial discharge pulse group is set to the value of the maximum absolute value $q_{max}$ of the charge quantity.

Then, when obtaining the affirmative result in step S14 by finishing the processes in steps S12 to S13 for all the partial discharge pulses PL constituting the target partial discharge pulse group in due course, the distribution pattern generation unit 40 resets the count value i of the loop counter (S15).

Subsequently, after incrementing the count value i of the loop counter, the distribution pattern generation unit 40 calculates a standardized charge quantity sq [i] obtained by standardizing the charge quantity q [i] of the i-th detected partial discharge pulse PL in the target partial discharge pulse group by the above-described Equation (2) (S16).

Next, the distribution pattern generation unit 40 determines whether or not the count value i of the loop counter has become the count value qc of the partial discharge pulse counter finally obtained in step S6 of FIG. 10 for the target partial discharge pulse group, similarly to step S14 (S17).

When a negative result is obtained in this determination, the distribution pattern generation unit 40 returns to step S16, and thereafter repeats a loop of steps S16-S17-S16 until an affirmative result is obtained in step S17. By this repetitive processing, the standardized charge quantity sq of each partial discharge pulse PL constituting the target partial discharge pulse group is calculated.

Then, when obtaining the affirmative result in step S17 by finishing the calculation of the standardized charge quantity sq of all the partial discharge pulses PL constituting the target partial discharge pulse group in due course, the distribution pattern generation unit 40 finishes the process of standardizing the partial discharge pulse charge quantity.

(1-3-2-2) Process of initializing counter

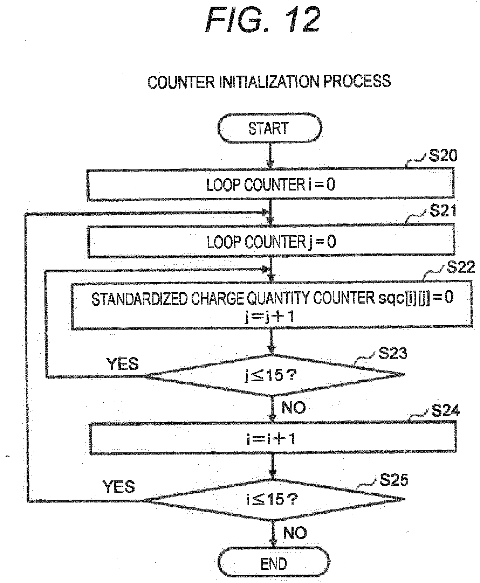

FIG. 12 illustrates a processing procedure of process of initializing counter executed by the distribution pattern generation unit 40. The distribution pattern generation unit 40 initializes the partial discharge pulse counter of each cell 51 in the standardized phase-resolved partial discharge pattern T' described above with reference to FIG. 6(B) according to the processing procedure illustrated in FIG. 12.

In practice, when starting the process of initializing the counter, the distribution pattern generation unit 40 first resets (sets to 0) the count value i of the first loop counter associated with the standardized charge quantity (standardized charge quantity sq) (S20), and resets the count value j of the second loop counter associated with the standardized phase angle (standardized phase angle sd) (S21).

Subsequently, the distribution pattern generation unit 40 resets the value of the count value sqc of the partial discharge pulse counter of the cell 51 in which the value of the standardized charge quantity sq matches the count value i of the first loop counter at that time and the value of the standardized phase angle sd matches the count value j of the second loop counter at that time to 0, and increments the count value j of the second loop counter (S22).

Next, the distribution pattern generation unit 40 determines whether or not the value of the count value j of the second loop counter is less than 15 (S23). When the affirmative result is obtained in this determination, the distribution pattern generation unit 40 returns to step S22, and then repeats the loop of steps S22-S23-S22.

When obtaining the negative result in step S23 by finishing resetting the count values sqc of the partial discharge pulse counters of all the cells 51 in which the value of the standardized phase angle sd is 0 in due course, the distribution pattern generation unit 40 increments the count value i of the first loop counter (S24), and thereafter, determines whether or not the count value i is less than 15 (S25).

When the affirmative result is obtained in this determination, the distribution pattern generation unit 40 returns to step S21, and then repeats the loop of steps S21 to S25. Then, when obtaining the negative result in step S25 by finishing resetting the count value sqc of the partial discharge pulse counter of all the cells 51 in due course, the distribution pattern generation unit 50 finishes the process of initializing counter.

(1-3-2-3) Process of aggregating partial discharge pulse

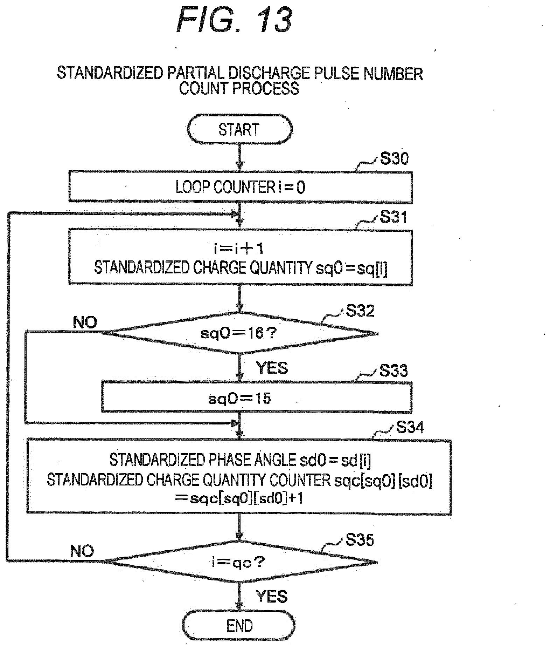

FIG. 13 illustrates a processing procedure of process of aggregating partial discharge pulse executed by the distribution pattern generation unit 40 after finishing the process of initializing counter (FIG. 12). The distribution pattern generation unit 40 aggregates the number of partial discharge pulses corresponding to each cell 51 of the standardized phase-resolved partial discharge pattern T' illustrated in FIG. 6(B) according to the processing procedure illustrated in FIG. 13.

In practice, the distribution pattern generation unit 40 first resets the value of the count value i of the loop counter (S30), then increments the value of the count value i, and substitutes the standardized charge quantity sq [i] of the i-th detected partial discharge pulse PL among the partial discharge pulses PL constituting the target partial discharge pulse group into the standardized charge quantity sq0 (S31).

Subsequently, the distribution pattern generation unit 40 determines whether or not the value of the standardized charge quantity sq0 is 16 (S32). If a negative result is obtained in this determination, the distribution pattern generation unit 40 proceeds to step S34. On the other hand, when the affirmative result is obtained in the determination of step S32, the distribution pattern generation unit 40 changes the value of the standardized charge quantity sq0 to 15 (S33).

Next, the distribution pattern generation unit 40 substitutes the standardized phase angle sd[i] of the i-th detected partial discharge pulse PL among the partial discharge pulses PL constituting the target partial discharge pulse group into the standardized phase angle sd0, and increments the count values sqc [sq0] [sd0] of the partial discharge pulse counter of the cell 51 (FIG. 6(B)) in which the standardized charge quantity is sq0 and the standardized phase angle is sd0 (S34).

Next, the distribution pattern generation unit 40 determines whether or - not the count value i of the loop counter matches the count value qc of the partial discharge pulse counter finally obtained in step S6 of FIG. 10 for the target partial discharge pulse group, that is, the total number of partial discharge pulses PL constituting the target partial discharge pulse group (S35).

When a negative result is obtained in this determination, the distribution pattern generation unit 40 returns to step S31, and thereafter, repeats the processes of steps S31 to S35 until an affirmative result is obtained in step S35. By this repetitive processing, the count value sqc of the standardized partial discharge pulse number counter of the cell 51 for each partial discharge pulse PL constituting the target partial discharge pulse group is counted up.

When obtaining the affirmative result in step S35 by finishing the process in step S34 for all the partial discharge pulses PL constituting the target partial discharge pulse group in due course, the distribution pattern generation unit 40 finishes the process of aggregating partial discharge pulse.

(1-4) Effects of present embodiment

As described above, in the partial discharge determination apparatus 4 of the present embodiment, the current standardized phase-resolved partial discharge pattern T' is classified into the category according to the degree of progress of the partial discharge in the underground power transmission cable 2 using the differential data between the previous and current standardized phase-resolved partial discharge patterns T' in addition to the data of the current phase-resolved partial discharge pattern T.

Therefore, according to the present partial discharge determination apparatus 4, the information indicating the variation in the charge quantity and the occurrence phase angle of the partial discharge is included as the determination element, the current standardized phase-resolved partial discharge pattern T' can be classified into the category according to the degree of progress of the partial discharge of the underground power transmission cable 2, and based on this, the degradation diagnosis of the underground power transmission cable 2 can be performed. Therefore, the diagnosis can be performed with higher accuracy as compared with the case of performing the diagnosis based only on the distribution pattern of the charge quantity and the phase angle of the partial discharge pulse PL.

(2) Second embodiment

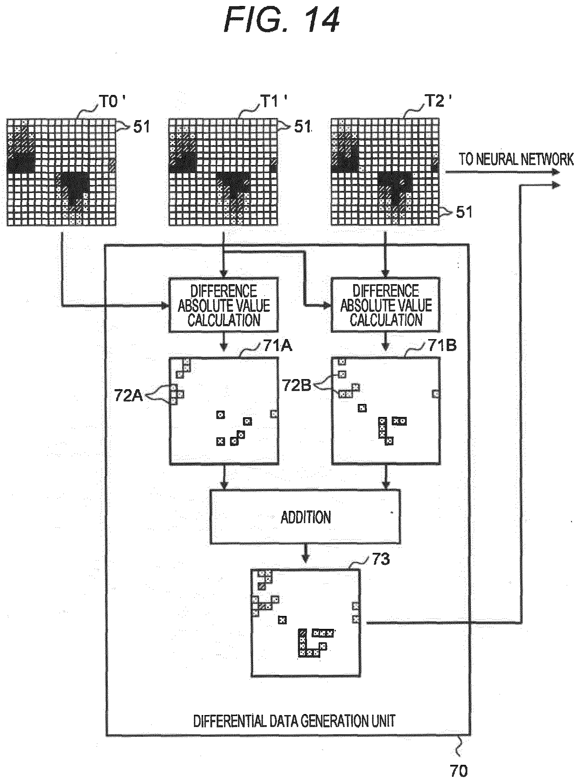

In FIG. 14, reference numeral 70 denotes a differential data generation unit according to the second embodiment applied to the partial discharge determination apparatus 4 instead of the differential data generation unit 41 in FIG. 3.

A differential data generation unit 70 according to the present embodiment is different from the differential data generation unit 41 according to the first embodiment in that differential data is calculated using not only the previous and current standardized phase-resolved partial discharge patterns T1' and T2' but also a next-to-last standardized phase-resolved partial discharge pattern T0'.

In practice, the differential data generation unit 70 of the present embodiment calculates the partial discharge occurrence number difference absolute value for each of the cells 51 in the next-to-last and previous standardized phase-resolved partial discharge patterns T0' and T1', thereby acquiring the distribution (hereinafter, this is referred to as a first partial discharge occurrence number difference absolute value distribution) 71A of the partial discharge occurrence number difference absolute value between the next-to-last and previous standardized phase-resolved partial discharge patterns T0' and T1'.

In addition, the differential data generation unit 70 of the present embodiment calculates the standardized partial discharge occurrence number difference absolute value for each of the cells 51 in the previous and current standardized phase-resolved partial discharge patterns T1' and T2', thereby acquiring the distribution (hereinafter, this is referred to as a second partial discharge occurrence number difference absolute value distribution) 71B of the partial discharge occurrence number difference absolute value between the previous and current standardized phase-resolved partial discharge patterns T1' and T2'.

Then, the differential data generation unit 70 adds the partial discharge occurrence number difference absolute value of each cell 72A in the first partial discharge occurrence number difference absolute value distribution 71A acquired as described above and the partial discharge occurrence number difference absolute value of each cell 72B in the second standardized partial discharge occurrence number difference absolute value distribution 71B for each of the corresponding cells 72A and 72B to generate one partial discharge occurrence number difference absolute value distribution 73, and outputs data of the generated partial discharge occurrence number difference absolute value distribution 73 to the neural network 36 described above with reference to FIG. 9 as differential data.

By using such a differential data generation unit 70 of the present embodiment, it is possible to obtain the partial discharge occurrence number difference absolute value distribution 73 in which the temporal variation of the partial discharge is more emphasized as compared with the partial discharge occurrence number difference absolute value distribution 52 of the first embodiment described above with reference to FIG. 8, and as a result, it is possible to determine the degree of progress of the partial discharge of the target underground power transmission cable 2 more accurately as compared with the first embodiment.

(3) Third embodiment

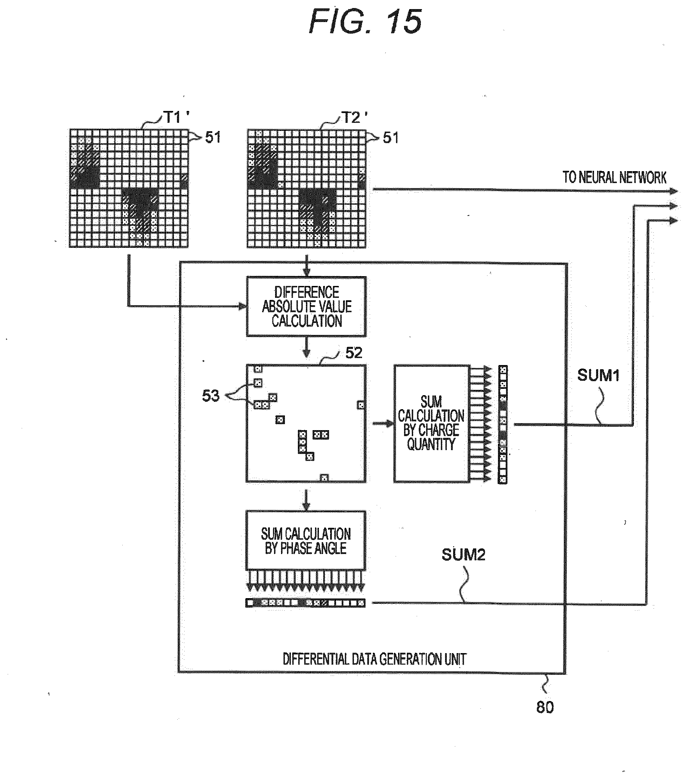

In FIG. 15 in which a part corresponding to that in FIG. 8 is denoted by the same reference numeral, reference numeral 80 denotes a differential data generation unit according to the third embodiment applied to the partial discharge determination apparatus 4 instead of the differential data generation unit 41 in FIG. 3.

The differential data generation unit 80 is different from the differential data generation unit 41 of the first embodiment in that the sum of the partial discharge occurrence number for each standardized charge quantity and for each standardized phase angle of the partial discharge occurrence number difference absolute value distribution 52 obtained based on the previous and current standardized phase-resolved partial discharge patterns T1' and T2' is calculated.

In practice, similarly to the differential data generation unit 41 of the first embodiment, the differential data generation unit 80 of the present embodiment calculates the partial discharge occurrence number difference absolute value for each of the cells 51 in the previous and current standardized phase-resolved partial discharge patterns T1' and T2', thereby acquiring the distribution (standardized partial discharge occurrence number difference absolute value distribution) 52 of the partial discharge occurrence number difference absolute value between the previous and current standardized phase-resolved partial discharge patterns T1' and T2'.

Then, the differential data generation unit 80 performs sum calculation of adding all the partial discharge occurrence number difference absolute values of the respective cells 53 (all the cells 53 of the row) of the standardized charge quantity for each of the same standardized charge quantities (that is, for each of the same rows) of the partial discharge occurrence number difference absolute value distribution 52 (block of "sum calculation by charge quantity" in FIG. 15), and outputs the calculation result for each standardized charge quantity thus obtained to the neural network held by the AI unit 42 as a sum SUM1 of partial discharge occurrence number difference absolute values for each charge quantity.

In addition, the differential data generation unit 80 performs sum calculation of adding all the partial discharge occurrence number difference absolute values of the respective cells 53 (all the cells 53 of the column) of the standardized phase angle for each of the same standardized phase angles (that is, for each of the same columns) of the partial discharge occurrence number difference absolute value distribution 52 (block of "sum calculation by phase angle" in FIG. 15), and outputs the calculation result for each standardized phase angle thus obtained to the neural network held by the AI unit 42 as a sum SUM2 of partial discharge occurrence number difference absolute values by phase angle.

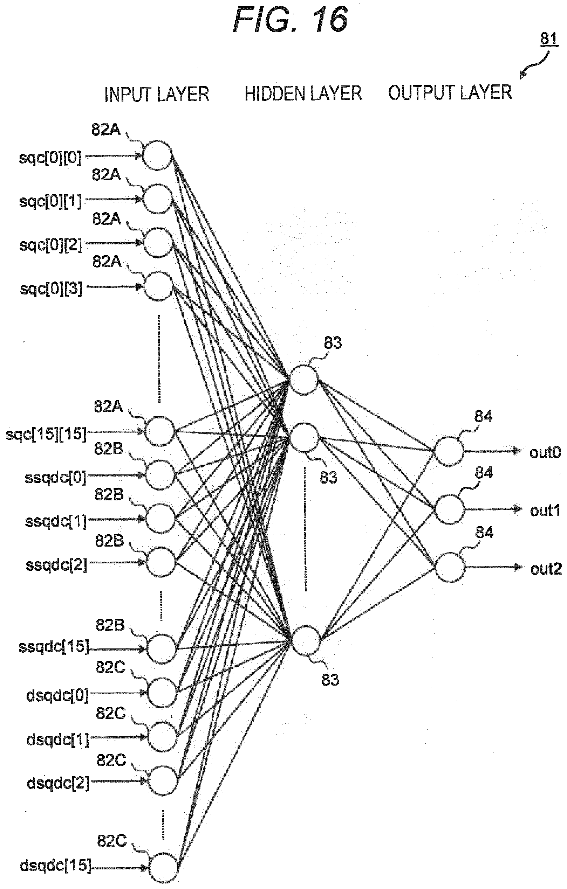

On the other hand, FIG. 16 illustrates a configuration example of the neural network 81 of the present embodiment. FIG. 16 is an example of a case where the neural network 81 includes a perceptron including an input layer, a hidden layer, and an output layer.

In the neural network 81, the first unit 82A corresponding to each cell 53 (FIG. 15) of a current phase-resolved partial discharge 52 (FIG. 15) is provided in the input layer, and the count value sqc [sq] [sd] of the partial discharge pulse counter of the corresponding cell 51 in the current standardized phase-resolved partial discharge pattern T2' is input to each of the first units 82A.

In the input layer of the neural network 81, first units 82B each corresponding to the standardized charge quantity are also provided in the input layer, and the sum SUM1 of partial discharge occurrence number difference absolute values for each charge quantity of the corresponding standardized charge quantity is input to these first units 82B. In addition, in the input layer of the neural network 81, first units 82C each corresponding to the standardized phase angle are also provided in the input layer, and the sum SUM2 of partial discharge occurrence number difference absolute values for each phase angle of the corresponding standardized phase angle is input to these first units 82C.

The hidden layer is provided with a smaller number of second units 83 than the total number of first units 82A and 82C in the input layer. The value input to each of the first units 82A to 82C of the input layer is weighted by a preset weight on a line connecting each of the first units 82A to 82C and the corresponding second unit 83 of the hidden layer, and is output to the second unit 83. Each second unit 83 calculates a sum of input values from each first units 82A to 82C.

The output layer is provided with a smaller number of third units 84 than the total number of second units 83. The sum of the input values to that second unit 83 respectively calculated in each second unit 83 of the hidden layer is weighted by a preset weight on a line connecting that second unit 83 and the corresponding third unit 84 of the output layer, and is output to the third unit 84. Each of the third units 84 calculates a sum of input values from each of the second units 83, and outputs a calculation result.

Note that, in the present embodiment, three third units 84 of the output layer are provided, and thereby inputs to the input layer are classified into three categories and output from the neural network 81. Then, the output of the neural network 81 is transmitted as a partial discharge determination signal to the cable degradation monitoring apparatus 5 (FIG. 1) via the transmission frame generation unit 43 (FIG. 3) and the transmitter 25 (FIG. 3) as a determination result of the progress of the partial discharge.

According to the partial discharge determination apparatus of the present embodiment using the differential data generation unit 70 and the neural network 81 described above, the amount of computation of the differential data generation unit 70 can be reduced as compared with the partial discharge determination apparatus 4 according to the first embodiment. Therefore, in addition to the effect obtained by the first embodiment, it is possible to obtain an effect that the processing time can be shortened.

(4) Fourth embodiment

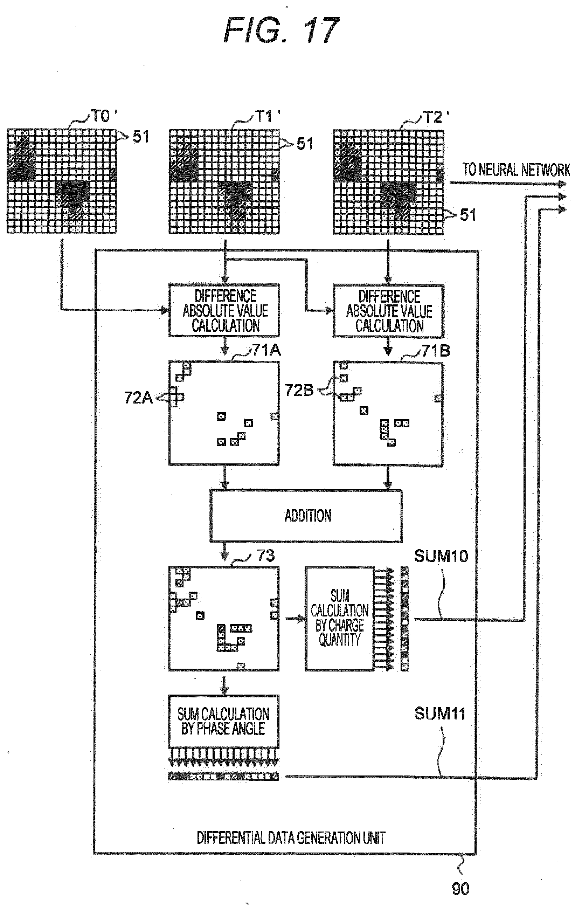

In FIG. 17 in which a part corresponding to that in FIG. 14 is denoted by the same reference numeral, reference numeral 90 denotes a differential data generation unit according to the fourth embodiment applied to the partial discharge determination apparatus 4 instead of the differential data generation unit 41 in FIG. 3.

The differential data generation unit 90 is different from the differential data generation unit 70 of the second embodiment in that the sum of the partial discharge occurrence number for each standardized charge quantity (standardized charge quantity) and for each standardized phase angle (standardized phase angle) of the partial discharge occurrence number difference absolute value distribution 73 obtained based on three of the next-to-last, previous, and current standardized phase-resolved partial discharge patterns T0' to T2' is calculated.

In practice, the differential data generation unit 90 of the present embodiment calculates the partial discharge occurrence number difference absolute value for each of the cells 51 in the next-to-last and previous standardized phase-resolved partial discharge patterns T0' and T1', thereby acquiring the distribution (first standardized partial discharge occurrence number difference absolute value distribution) 71A of the partial discharge occurrence number difference absolute value between the next-to-last and previous standardized phase-resolved partial discharge patterns T0' and T1'.

In addition, the differential data generation unit 90 of the present embodiment calculates the partial discharge occurrence number difference absolute value for each of the cells 51 in the previous and current standardized phase-resolved partial discharge patterns T1' and T2', thereby acquiring the distribution (second standardized partial discharge occurrence number difference absolute value distribution) 71B of the partial discharge occurrence number difference absolute value between the previous and current standardized phase-resolved partial discharge patterns T1' and T2'.

Then, the differential data generation unit 90 adds the partial discharge occurrence number difference absolute value of each cell 72A in the first partial discharge occurrence number difference absolute value distribution 71A acquired as described above and the partial discharge occurrence number difference absolute value of each cell 72B in the second partial discharge occurrence number difference absolute value distribution 71B for each of the corresponding cells 72A and 72B to generate one partial discharge occurrence number difference absolute value distribution 73.

In addition, the differential data generation unit 80 performs sum calculation of adding all the partial discharge occurrence number difference absolute values of the respective cells 53 (all the cells 53 of the row) of the standardized charge quantity for each of the same standardized charge quantities (that is, for each of the same rows) of the partial discharge occurrence number difference absolute value distribution 52 (block of "sum calculation by charge quantity" in FIG. 17), and outputs the calculation result for each standardized charge quantity thus obtained to the neural network held by the AI unit 42 as a sum SUM10 of partial discharge occurrence number difference absolute values for each charge quantity.

Further, the differential data generation unit 80 performs sum calculation of adding all the partial discharge occurrence number difference absolute values of the respective cells 53 (all the cells 53 of the column) of the standardized phase angle for each of the same standardized phase angles (that is, for each of the same columns) of the partial discharge occurrence number difference absolute value distribution 52 (block of "sum calculation by phase angle" in FIG. 17), and outputs the calculation result for each standardized phase angle thus obtained to the neural network held by the AI unit 42 as a sum SUM11 of partial discharge occurrence number difference absolute values by phase angle.

Note that the configuration of the neural network according to the present embodiment is similar to that of the neural network 81 according to the third embodiment described above with reference to FIG. 16, and thus the description thereof will be omitted here.

According to the partial discharge determination apparatus of the present embodiment using the differential data generation unit 90 and the neural network 81 described above, in addition to the effects obtained by the first and second embodiments, it is possible to obtain an effect of shortening the processing time as in the third embodiment.

(5) Other Embodiments

In the first to fourth embodiments, the case where the present invention is applied to the partial discharge determination apparatus 4 in which the determination target of the degree of progress of the partial discharge is the underground power transmission cable 2 has been described; however, the present invention is not limited thereto, and can be widely applied to various partial determination apparatuses that determine the degree of progress of the partial discharge of the power transmission cable other than the underground power transmission cable 2.

In the first to fourth embodiments described above, the case where the data registration unit 24 is configured by the FPGA has been described; however, the present invention is not limited thereto, and the data registration unit 24 may be configured as a functional unit of a software configuration embodied by the CPU 20 executing a corresponding program.

Furthermore, in the first to fourth embodiments described above, the case where the charge quantity and the occurrence phase angle are standardized using the data of the partial discharge pulse PL occurring in the period of 50 cycles of the applied voltage of the target underground power transmission cable 2 as one lump has been described; however, the present invention is not limited thereto, and the charge quantity and the occurrence phase angle may be standardized using the data of the partial discharge pulse PL occurring in one or a plurality of cycle periods other than the period of 50 cycles as one lump.

In the first to fourth embodiments, the case where the partial discharge occurrence number difference absolute value distributions 52 and 73 are generated based on the latest two or three standardized phase-resolved partial discharge patterns T' has been described; however, the present invention is not limited thereto, and the partial discharge occurrence number difference absolute value distributions 52 and 73 may be generated based on the latest four or more standardized phase-resolved partial discharge patterns T'.

Furthermore, in the first to fourth embodiments described above, the case where the AI unit 42 performs machine learning as to whether or not the current degree of progress of the partial discharge of the target underground power transmission cable 2 belongs to a category at the start of the partial discharge, the middle stage of the partial discharge, or immediately before the dielectric breakdown, and determines the degree of progress of the partial discharge in the target underground power transmission cable 2 using the neural networks 36 and 81 obtained by the learning has been described; however, the present invention is not limited thereto, and the neural networks 36 and 81 already created by the machine learning may be provided to the AI unit 42, and the AI unit 42 may determine the degree of progress of the partial discharge in the target underground power transmission cable 2 using the neural networks 36 and 81.

Industrial Applicability

The present invention can be widely applied to various partial discharge determination apparatus that determine a degree of progress of partial discharge occurring in a power transmission cable.

Reference Signs List

1 underground power transmission cable degradation monitoring system
2 underground power transmission cable
3 clamp type high-frequency CT
4 partial discharge determination apparatus
5 cable degradation monitoring apparatus
20 CPU
224 data registration unit
30 distribution pattern generation program
31, 70, 80, 90 differential data generation program
32 AI program
34 partial discharge data
35 standardized distribution pattern data
36, 81 neural network
40 distribution pattern generation unit
41 differential data generation unit
42 AI unit
52, 72A, 72B, 73 partial discharge occurrence number difference absolute value distribution
PL, PL1 to PL4 partial discharge pulse
SG1 applied voltage signal
SG2 partial discharge pulse signal
T phase-resolved partial discharge pattern
T', T0' to T2' standardized phase-resolved partial discharge pattern

**Claims**

1. A partial discharge determination apparatus (4) that determines a degree of progress of a partial discharge occurring in a power transmission cable (2), the apparatus (4) comprising:

   a distribution pattern generation unit (40) that generates a distribution pattern of a combination of a charge quantity and an occurrence phase angle of each of the partial discharges occurring in one or a plurality of cycle periods of an applied voltage of the power transmission cable (2);

   a differential data generation unit (41) that generates differential data including a difference between the numbers of occurrences of the partial discharges for each combination of the charge quantity and the occurrence phase angle in two or more latest distribution patterns generated by the distribution pattern generation unit (40), respectively; and

   a determination unit (42) that determines the degree of progress of the partial discharge based on data of the latest distribution patterns and the differential data, wherein

   the distribution pattern generation unit (40) standardizes the charge quantity and the occurrence phase angle of each of the partial discharges to generate the distribution pattern in which the numbers of occurrences of the partial discharge for each combination of the standardized charge quantity and occurrence phase angle are aggregated, and

   the determination unit (42) determines the degree of progress of the partial discharge by using data of the latest distribution pattern and the differential data as inputs, and wherein

   the differential data generation unit (41) generates, as the differential data, a result of a sum calculation by charge quantity obtained by adding a difference in the numbers of occurrences of the partial discharges for each combination of the standardized charge quantity and the occurrence phase angle in the two or more latest distribution patterns for each of the standardized charge quantities, wherein the partial discharge determination apparatus (4) is **characterized in that**:

   a result of a sum calculation by phase angle is obtained by adding a difference in the numbers of occurrences of the partial discharge for each of the combinations for each of the standardized occurrence phase angles.

2. The partial discharge determination apparatus (4) according to claim 1, wherein

   the determination unit (42) learns the degree of progress of the partial discharge based on data of the latest distribution pattern and the differential data to determine the degree of progress of the partial discharge using a neural network obtained by the learning.

3. The partial discharge determination apparatus (4) according to claim 2, wherein

   the determination unit (42) determines a state indicating the degree of progress of the partial discharge among a state at a start of the partial discharge, a middle stage of the partial discharge, or a state immediately before discharge breakdown.

4. A partial discharge determination method executed in a partial discharge determination apparatus (4) that determines a degree of progress of a partial discharge occurring in a power transmission cable (2), the method comprising:

   a first step of generating a distribution pattern of a combination of a charge quantity and an occurrence phase angle of each of the partial discharges occurring in one or a plurality of cycle periods of an applied voltage of the power transmission cable (2);

   a second step of generating differential data including a difference between the numbers of occurrences of the partial discharges for each combination of the charge quantity and the occurrence phase angle in two or more latest distribution patterns; and

   a third step of determining the degree of progress of the partial discharge based on data of the latest distribution patterns and the differential data, wherein

   the first step includes standardizing the charge quantity and the occurrence phase angle of each of the partial discharges to generate the distribution pattern in which the numbers of occurrences of the partial discharge for each combination of the standardized charge quantity and occurrence phase angle are aggregated, and

   the third step includes determining the degree of progress of the partial discharge by using data of the latest distribution pattern and the differential data as inputs, and wherein

   the second step includes generating, as the differential data, a result of a sum calculation by charge quantity obtained by adding a difference in the numbers of occurrences of the partial discharges for each combination of the standardized charge quantity and the occurrence phase angle in the two or more latest distribution patterns for each of the standardized charge quantities, wherein the partial discharge determination method is **characterized**

**in that**:
a result of a sum calculation by phase angle is obtained by adding a difference in the numbers of occurrences of the partial discharge for each of the combinations for each of the standardized occurrence phase angles.

5. The partial discharge determination method according to claim 4, wherein
the third step includes learning the degree of progress of the partial discharge based on data of the latest distribution pattern and the differential data to determine the degree of progress of the partial discharge using a neural network obtained by the learning.

6. The partial discharge determination method according to claim 5, wherein
the third step including determining a state indicating the degree of progress of the partial discharge among a state at a start of the partial discharge, a middle stage of the partial discharge, or a state immediately before discharge breakdown.

**Patentansprüche**

1. Vorrichtung zum Bestimmen einer Teilentladung (4), die einen Grad eines Fortschritts einer Teilentladung, die in einem Stromübertragungskabel (2) auftritt, bestimmt, wobei die Vorrichtung (4) umfasst:

eine Verteilungsmustererzeugungseinheit (40), die ein Verteilungsmuster einer Kombination einer Ladungsmenge und eines Phasenwinkels des Ereignisses jeder der Teilentladungen, die in einer oder mehreren Zyklusperioden einer angelegten Spannung des Stromübertragungskabels (2) auftreten, erzeugt;
eine Differenzialdatenerzeugungseinheit (41), die Differenzialdaten erzeugt, die einen Unterschied zwischen der Anzahl von Ereignissen der Teilentladungen für jede Kombination der Ladungsmenge und des Phasenwinkels des Ereignisses in zwei oder mehr letzten Verteilungsmustern, die jeweils durch die Verteilungsmustererzeugungseinheit (40) erzeugt werden, enthalten; und
eine Bestimmungseinheit (42), die den Grad des Fortschritts der Teilentladung anhand von Daten der letzten Verteilungsmuster und der Differenzialdaten bestimmt, wobei
die Verteilungsmustererzeugungseinheit (40) die Ladungsmenge und den Phasenwinkel des Ereignisses jeder der Teilentladungen standardisiert, um das Verteilungsmuster zu erzeugen, in dem die Anzahl der Ereignisse der Teilentladung für jede Kombination der standardisierten Ladungsmenge und des standardisierten Phasenwinkels des Ereignisses aggregiert sind, und
die Bestimmungseinheit (42) den Grad des Fortschritts der Teilentladung durch Verwenden von Daten des letzten Verteilungsmusters und der Differenzialdaten als Eingaben bestimmt, und wobei
die Differenzialdatenerzeugungseinheit (41) als die Differenzialdaten ein Ergebnis einer Summenberechnung durch eine Ladungsmenge, die durch Addieren eines Unterschieds der Anzahl der Ereignisse der Teilentladungen für jede Kombination der standardisierten Ladungsmenge und des standardisierten Phasenwinkels des Ereignisses in den zwei oder mehr letzten Verteilungsmustern für jede der standardisierten Ladungsmengen erhalten wird, erzeugt, wobei die Vorrichtung zur Bestimmung einer Teilentladung (4) **dadurch gekennzeichnet ist, dass**:
ein Ergebnis einer Summenberechnung durch einen Phasenwinkel durch Addieren eines Unterschieds der Anzahl von Ereignissen der Teilentladung für jede der Kombinationen für jeden der standardisierten Phasenwinkel des Ereignisses erhalten wird.

2. Vorrichtung zur Bestimmung einer Teilentladung (4) nach Anspruch 1, wobei
die Bestimmungseinheit (42) den Grad des Fortschritts der Teilentladung anhand von Daten des letzten Verteilungsmusters und der Differenzialdaten lernt, um den Grad des Fortschritts der Teilentladung unter Verwendung eines neuronalen Netzes, das durch das Lernen erhalten wird, zu bestimmen.

3. Vorrichtung zur Bestimmung einer Teilentladung (4) nach Anspruch 2, wobei
die Bestimmungseinheit (42) einen Zustand, der den Grad des Fortschritts der Teilentladung angibt, unter einem Zustand eines Starts der Teilentladung, einem mittleren Zustand der Teilentladung oder einem Zustand unmittelbar vor dem Entladungsausfall, bestimmt.

4. Verfahren zum Bestimmen einer Teilentladung, das in einer Vorrichtung zur Bestimmung einer Teilentladung (4) ausgeführt wird, das einen Grad eines Fortschritts einer Teilentladung bestimmt, die in einem Stromübertragungskabel (2) auftritt, wobei das Verfahren umfasst:

einen ersten Schritt des Erzeugens eines Verteilungsmusters einer Kombination einer Ladungsmenge und eines Phasenwinkels des Ereignisses jeder der Teilentladungen, die in einer oder mehreren Zyklusperioden einer angelegten Spannung des Stromübertragungskabels (2) auftreten;

einen zweiten Schritt des Erzeugens von Differenzialdaten, die einen Unterschied zwischen der Anzahl von Ereignissen der Teilentladungen für jede Kombination der Ladungsmenge und des Phasenwinkels des Ereignisses in zwei oder mehr letzten Verteilungsmustern enthalten; und

einen dritten Schritt des Bestimmens des Grads des Fortschritts der Teilentladung anhand von Daten der letzten Verteilungsmuster und der Differenzialdaten, wobei

der erste Schritt enthält, die Ladungsmenge und den Phasenwinkel des Ereignisses jeder der Teilentladungen zu standardisieren, um das Verteilungsmuster zu erzeugen, in dem die Anzahl der Ereignisse der Teilentladung für die Kombination der standardisierten Ladungsmenge und des standardisierten Phasenwinkels des Ereignisses aggregiert sind, und

der dritte Schritt enthält, den Grad des Fortschritts der Teilentladung durch Verwenden von Daten des letzten Verteilungsmusters und der Differenzialdaten als Eingaben zu bestimmen, und wobei

der zweite Schritt enthält, als die Differenzialdaten ein Ergebnis einer Summenberechnung durch eine Ladungsmenge, die durch Addieren eines Unterschieds der Anzahl der Ereignisse der Teilentladungen für jede Kombination der standardisierten Ladungsmenge und des standardisierten Phasenwinkels des Ereignisses in den zwei oder mehr letzten Verteilungsmustern für jede der standardisierten Ladungsmengen erhalten wird, zu erzeugen, wobei das Verfahren zur Bestimmung einer Teilentladung **dadurch gekennzeichnet ist, dass**:

ein Ergebnis einer Summenberechnung durch einen Phasenwinkel durch Addieren eines Unterschieds der Anzahl von Ereignissen der Teilentladung für jede der Kombinationen für jeden der standardisierten Phasenwinkel des Ereignisses erhalten wird.

5. Verfahren zur Bestimmung einer Teilentladung nach Anspruch 4, wobei
der dritte Schritt enthält, den Grad des Fortschritts der Teilentladung anhand von Daten des letzten Verteilungsmusters und der Differenzialdaten zu lernen, um den Grad des Fortschritts der Teilentladung unter Verwendung eines neuronalen Netzes, das durch das Lernen erhalten wird, zu bestimmen.

6. Verfahren zur Bestimmung einer Teilentladung nach Anspruch 5, wobei
der dritte Schritt enthält, einen Zustand, der den Grad des Fortschritts der Teilentladung angibt, unter einem Zustand eines Starts der Teilentladung, einem mittleren Zustand der Teilentladung oder einem Zustand unmittelbar vor dem Entladungsausfall zu bestimmen.

**Revendications**

1. Appareil de détermination de décharge partielle (4) qui détermine un degré de progression d'une décharge partielle survenant dans un câble de transmission de puissance (2), l'appareil (4) comprenant :

une unité de génération de motif de distribution (40) qui génère un motif de distribution d'une combinaison d'une quantité de charge et d'un angle de phase d'occurrence de chacune des décharges partielles survenant pendant une ou une pluralité de périodes cycliques d'une tension appliquée du câble de transmission de puissance (2) ;

une unité de génération de données différentielles (41) qui génère des données différentielles incluant une différence entre le nombre d'occurrences des décharges partielles pour chaque combinaison de la quantité de charge et de l'angle de phase d'occurrence dans deux ou plusieurs motifs de distribution les plus récents générés par l'unité de génération de motif de distribution (40), respectivement ; et

une unité de détermination (42) qui détermine le degré de progression de la décharge partielle sur la base de données des motifs de distribution les plus récents et des données différentielles, dans lequel

l'unité de génération de motif de distribution (40) standardise la quantité de charge et l'angle de phase d'occurrence de chacune des décharges partielles pour générer le motif de distribution dans lequel les nombres d'occurrences de la décharge partielle pour chaque combinaison de la quantité de charge et de l'angle de phase d'occurrence standardisés sont agrégées, et

l'unité de détermination (40) détermine le degré de progression de la décharge partielle en utilisant des données du motif de distribution le plus récent et les données différentielles à titre d'entrée, et dans lequel

l'unité de génération de données différentielles (41) génère, à titre de données différentielles, un résultat d'un calcul de somme par quantité de charge obtenu en additionnant une différence dans les nombres d'occurrences des décharges partielles pour chaque combinaison de la quantité de charge et de l'angle de phase d'occurrence standardisés dans les deux ou plusieurs motifs de distribution les plus récents pour chacune des quantités de charge standardisées, dans lequel

l'appareil de détermination de décharge partielle (4) est **caractérisé en ce que** :

un résultat d'un calcul de somme par angle de phase est obtenu en ajoutant une différence dans les nombres d'occurrences de la décharge partielle pour chacune des combinaisons pour chacun des angles de phase d'occurrence standardisés.

2. Appareil de détermination de décharge partielle (4) selon la revendication 1, dans lequel
l'unité de détermination (42) apprend le degré de progression de la décharge partielle sur la base de données du motif de distribution le plus récent et des données différentielles pour déterminer le degré de progression de la décharge partielle en utilisant un réseau de neurones obtenu via l'apprentissage.

3. Appareil de détermination de décharge partielle (4) selon la revendication 2, dans lequel
l'unité de détermination (42) détermine un état indiquant le degré de progression de la décharge partielle parmi un état à un début de la décharge partielle, une phase médiane de la décharge partielle, ou un état immédiatement avant la panne de décharge.

4. Procédé de détermination de décharge partielle exécuté dans un appareil de détermination de décharge partielle (4) qui détermine un degré de progression d'une décharge partielle survenant dans un câble de transmission de puissance (2), le procédé comprenant :

une première étape consistant à générer un motif de distribution d'une combinaison d'une quantité de charge et d'un angle de phase d'occurrence de chacune des décharges partielles survenant pendant une ou une pluralité de périodes cycliques d'une tension appliquée du câble de transmission de puissance (2) ;
une deuxième étape consistant à générer des données différentielles incluant une différence entre le nombre d'occurrences des décharges partielles pour chaque combinaison de la quantité de charge et de l'angle de phase d'occurrence dans deux ou plusieurs motifs de distribution les plus récents ; et
une troisième étape consistant à déterminer le degré de progression de la décharge partielle sur la base de données des motifs de distribution les plus récents et des données différentielles, dans lequel
la troisième étape inclut de standardiser la quantité de charge et l'angle de phase d'occurrence de chacune des décharges partielles pour générer le motif de distribution dans lequel les nombres d'occurrences de la décharge partielle pour chaque combinaison de la quantité de charge et de l'angle de phase d'occurrence standardisés sont agrégées, et
la troisième étape inclut de déterminer le degré de progression de la décharge partielle en utilisant des données du motif de distribution le plus récent et les données différentielles à titre d'entrée, et dans lequel
la deuxième étape inclut de générer, à titre de données différentielles, un résultat d'un calcul de somme par quantité de charge obtenu en additionnant une différence dans les nombres d'occurrences des décharges partielles pour chaque combinaison de la quantité de charge et de l'angle de phase d'occurrence standardisés dans les deux ou plusieurs motifs de distribution les plus récents pour chacune des quantités de charge standardisées, dans lequel
le procédé de détermination de décharge partielle est **caractérisé en ce que** : un résultat d'un calcul de somme par angle de phase est obtenu en ajoutant une différence dans les nombres d'occurrences de la décharge partielle pour chacune des combinaisons pour chacun des angles de phase d'occurrence standardisés.

5. Procédé de détermination de décharge partielle selon la revendication 4, dans lequel
la troisième étape inclut d'apprendre le degré de progression de la décharge partielle sur la base de données du motif de distribution le plus récent et des données différentielles pour déterminer le degré de progression de la décharge partielle en utilisant un réseau de neurones obtenu via l'apprentissage.

6. Procédé de détermination de décharge partielle selon la revendication 5 dans lequel
la troisième étape inclut de déterminer un état indiquant le degré de progression de la décharge partielle parmi un état à un début de la décharge partielle, une phase médiane de la décharge partielle, ou un état immédiatement avant la panne de décharge.

# FIG. 1

UNDERGROUND POWER TRANSMISSION CABLE
DEGRADATION MONITORING SYSTEM

# FIG. 2

PARTIAL DISCHARGE DETERMINATION APPARATUS ~4

20 CPU

23 A/D

24 DATA REGISTRATION UNIT

25 TRANSMITTER

21 MEMORY

30 DISTRIBUTION PATTERN GENERATION

31 DIFFERENTIAL DATA GENERATION

32 AI

33 TRANSMISSION FRAME GENERATION

22 STORAGE DEVICE

34 PARTIAL DISCHARGE DATA

35 STANDARDIZED DISTRIBUTION PATTERN DATA

36 NEURAL NETWORK

# FIG. 3

# FIG. 4

(A) PARTIAL DISCHARGE PULSE SIGNAL

(B) APPLIED VOLTAGE SIGNAL

(C) APPLIED VOLTAGE PHASE ANGLE

(D) APPLIED VOLTAGE CYCLE

# FIG. 5

(A) AT THE START OF PARTIAL DISCHARGE

(B) MID-TERM PARTIAL DISCHARGE

(C) IMMEDIATELY BEFORE DIELECTRIC BREAKDOWN

# FIG. 6

(A) PHASE-RESOLVED PARTIAL
DISCHARGE PATTERN T

(B) STANDARDIZED PHASE-RESOLVED
PARTIAL DISCHARGE PATTERN T'

# FIG. 7

(A) PARTIAL DISCHARGE PULSE SIGNAL

(B) STANDARDIZED PARTIAL DISCHARGE PULSE SIGNAL

# FIG. 8

# FIG. 9

INPUT LAYER        HIDDEN LAYER        OUTPUT LAYER

36

60A

sqc[0][0]

60A

sqc[0][1]

60A

sqc[0][2]

60A

sqc[0][3]

61

62

60A

sqc[15][15]

60B

sqdc[0][0]

61

out0

62

out1

60B

sqdc[0][1]

60B

sqdc[0][2]

61

62

60B

sqdc[0][3]

out2

60B

sqdc[15][15]

# FIG. 10

PARTIAL DISCHARGE PULSE INFORMATION
REGISTRATION PROCESS

# FIG. 11

PARTIAL DISCHARGE PULSE CHARGE QUANTITY
STANDARDIZATION PROCESS

START

S10
MAXIMUM ABSOLUTE VALUE OF CHARGE QUANTITY qmax=0
LOOP COUNTER i=0

S11
i=i+1
ABSOLUTE VALUE OF CHARGE QUANTITY q0=q[i]

S12
q0>qmax?  NO

YES    S13
qmax=q0

S14
i=qc?  NO

YES    S15
LOOP COUNTER i=0

S16
i=i+1
STANDARDIZED CHARGE QUANTITY sq[i]
=int(8 × (q[i]+qmax)/qmax)

S17
i=qc?  NO

YES
END

# FIG. 12

COUNTER INITIALIZATION PROCESS

START

S20
LOOP COUNTER i = 0

S21
LOOP COUNTER j = 0

S22
STANDARDIZED CHARGE QUANTITY COUNTER sqc[i][j] = 0
j = j + 1

S23
YES — $j \leq 15$ ?
NO

S24
i = i + 1

S25
YES — $i \leq 15$ ?
NO

END

# FIG. 13

STANDARDIZED PARTIAL DISCHARGE PULSE NUMBER
COUNT PROCESS

```
            START
              │
              ▼                    S30
   ┌──────────────────────────┐
   │   LOOP COUNTER i = 0      │
   └──────────────────────────┘
              │
              ▼                    S31
   ┌──────────────────────────┐
   │         i = i + 1         │
   │ STANDARDIZED CHARGE       │
   │ QUANTITY sq0 = sq[i]      │
   └──────────────────────────┘
              │
              ▼                    S32
   NO    ◇  sq0 = 16 ?  ◇
              │
             YES                   S33
   ┌──────────────────────────┐
   │        sq0 = 15          │
   └──────────────────────────┘
              │
              ▼                    S34
   ┌────────────────────────────────────────┐
   │ STANDARDIZED PHASE ANGLE sd0 = sd[i]   │
   │ STANDARDIZED CHARGE QUANTITY COUNTER    │
   │ sqc[sq0][sd0] = sqc[sq0][sd0]+1        │
   └────────────────────────────────────────┘
              │
              ▼                    S35
   NO    ◇   i = qc ?   ◇
              │
             YES
            END
```

# FIG. 14

TO NEURAL NETWORK

DIFFERENCE ABSOLUTE VALUE CALCULATION

DIFFERENCE ABSOLUTE VALUE CALCULATION

ADDITION

DIFFERENTIAL DATA GENERATION UNIT

# FIG. 15

# FIG. 16

81

INPUT LAYER    HIDDEN LAYER    OUTPUT LAYER

82A
sqc[0][0]

82A
sqc[0][1]

82A
sqc[0][2]

82A
sqc[0][3]

82A
sqc[15][15]

82B
ssqdc[0]

82B
ssqdc[1]

82B
ssqdc[2]

82B
ssqdc[15]

82C
dsqdc[0]

82C
dsqdc[1]

82C
dsqdc[2]

82C
dsqdc[15]

83

83

83

84    out0

84    out1

84    out2

# FIG. 17

T0'  51

T1'  51

T2'  51

TO NEURAL NETWORK

DIFFERENCE ABSOLUTE VALUE CALCULATION

DIFFERENCE ABSOLUTE VALUE CALCULATION

71A

71B

72A

72B

ADDITION

73

SUM CALCULATION BY CHARGE QUANTITY

SUM10

SUM CALCULATION BY PHASE ANGLE

SUM11

DIFFERENTIAL DATA GENERATION UNIT

90

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 10078471 A
- JP 2005331415 A
- KR 101574615 B1
- JP 2000214211 A

### Non-patent literature cited in the description

- **KOMORI FUMITAKA**. Degradation Diagnosis and Estimation of Residual Life of Insulating Material using Pattern Recognition of Phase Angle Resolved Partial Discharge Pulse Occurrence Distribution. The Institute of Electrical Engineers of Japan, 1993, vol. 113-A, 586-593